Europäisches Patentamt

European Patent Office

Office européen des brevets

(11) Veröffentlichungsnummer: **0 219 098 B1**

## (12) EUROPÄISCHE PATENTSCHRIFT

(45) Veröffentlichungstag der Patentschrift: **11.03.92**

(21) Anmeldenummer: **86114220.6**

(22) Anmeldetag: **14.10.86**

(51) Int. Cl.5: **G01S 7/52**, G01S 7/62, G01S 7/66, H04N 5/21, H03H 17/04

(54) **Bildsignalaufbereitungsvorrichtung für ein Ultraschall-Abbildungssystem und Abbildungsgerät.**

(30) Priorität: **16.10.85 CH 4456/85**

(43) Veröffentlichungstag der Anmeldung:
**22.04.87 Patentblatt 87/17**

(45) Bekanntmachung des Hinweises auf die
Patenterteilung:
**11.03.92 Patentblatt 92/11**

(84) Benannte Vertragsstaaten:
**CH DE FR GB IT LI NL SE**

(56) Entgegenhaltungen:
**EP-A- 0 004 728**
**GB-A- 2 015 847**
**US-A- 4 240 106**
**US-A- 4 319 489**
**US-A- 4 375 671**

**SMPTE JOURNAL, Band 87, Nr. 3, März 1978,
Seiten 129-133, Scarsdale, New York, US;
R.H. McMANN et al.: "A digital noise reducer
for encoded NTSC signals"**

**IEE PROCEEDINGS, Band 127, Nr. 2, Teil G,
April 1980, Seiten 52-56, Hitchin, Herts, GB;**

**T.J. DENNIS: "Nonlinear temporal filter for
television picture noise reduction"**

**IEE PROCEEDINGS, Band 122, Nr. 2, Februar
1975, Seiten 137-141, Stevenage, GB; A.R.
ELLIOTT et al.: "Hardware implementation of
a recursive digital filter for M.T.I. radar"**

(73) Patentinhaber: **KONTRON INSTRUMENTS HOL-
DING N.V.
Pietermaai 6 A P.O. Box 504
Curacao(AN)**

(72) Erfinder: **Dousse, Bruno
Eisenbahnweg 18
CH-4058 Basel(CH)**

(74) Vertreter: **Körber, Wolfhart, Dr.rer.nat. et al
Patentanwälte Dipl.-Ing. H. Mitscherlich
Dipl.-Ing. K. Gunschmann Dr.rer.nat. W. Körber Dipl.Ing. J. Schmidt-Evers Dipl.-Ing. W.
Melzer Steinsdorfstrasse 10
W-8000 München 22(DE)**

**Beschreibung**

Die vorliegende Erfindung betrifft eine Bildsignalaufbereitungsvorrichtung für ein Ultraschall-Abbildungssystem und mit den Merkmalen des Oberbegriffes der Ansprüche 1 bzw. 2 bzw. 3.

Zum Beispiel aus der US-A-4319489 ist ein System zur Erzeugung von Ultraschall-Querschnittbildern eines Körpers bekannt. Mit diesem System werden eine Vielzahl von aufeinanderfolgenden, sich wenigstens teilweise überdeckenden und nach dem Impulsechoverfahren in einer Abtastebene zweilenweise durchgeführten Abtastungen des Körpers ausgeführt. Dadurch können Bildsignale in digitaler Form erzeugt werden, die den empfangenen Echos entsprechen, wobei jede Abtastung eine vorbestimmte Anzahl Abtastlinien und jede von diesen eine vorbestimmte Anzahl Abtastpunkte umfasst. Zwischen korrespondierenden Abtastpunkten aufeinanderfolgender Abtastungen ist ein vorbestimmtes Zeitintervall vorgesehen. Das bekannte System umfaßt die Abtastvorrichtung mit Sender und Empfänger, einen Monitor und eine Steuereinrichtung.

Es ist bekannt (IEEE Transactions on Sonics and Ultrasonics, Vol. SU-31, No. 4, Juli 1984, Seiten 195-217), dass bei Verfahren der oben erwähnten Art eine Verringerung des Rauschens, das die Bildqualität vermindert, durch Mittelung der Bildsignale über eine Folge von Bildern erzielt werden kann, dass dabei aber Bewegungen im untersuchten Bereich eine Verwischung des resultierenden Bildes verursachen. Dies ist insbesondere bei der medizinischen Ultraschall-Diagnostik ein erheblicher Nachteil.

Aus der Fernseh- und Radartechnik ist es bekannt, Nutz-/Rauschsignalverbesserungen durch Verwendung rekursiver Filter in der Signalverarbeitung zu erreichen. Beispiele hierfür sind beschrieben in "SMPTE Journal", Vol. 87 (1978), S. 129-133, in "IEE Proc.", Vol. 127 (1980), S. 52-56 und in "Proc. IEE", Vol. 122 (1975), S. 137-141.

Insbesondere in der hier erstgenannten Druckschrift (SMPTE Journal) ist die Arbeits- und Wirkungsweise eines solchen rekursiven Filters als für den Elektroniker bekannt zu entnehmen. Es ist dort ein für das Filter wählbarer K-Faktor in seiner Bedeutung und Wirkung beschrieben, und zwar im Hinblick auf in der Bildsignalfolge im Augenblick enthaltenen Änderungen, d.h. in Bezug auf Bewegungen in der von der Fernsehkamera aufgenommenen Szene. In der Radartechnik wird dagegen die Bewegung des zu detektierenden Flugzeuges oder dgl. zur Signalanhebung aus dem Rauschen verwendet.

Der Erfindung liegt daher die Aufgabe zugrunde, von Körpern Ultraschall-Abtastbilder mit grossem Nutz-/Rauschsignalverhältnis bei Vermeidung einer Bild-Qualitätsminderung bei Auftreten von Bewegungen der Körper zu ermöglichen.

Diese Aufgabe wird mit den Merkmalen des Anspruches 1 bzw. des Anspruches 2 bzw. des Anspruches 3 gelöst.

Die Erfindung beruht auf dem Gedanken, für wenigstens einen Teil der Bildpunkte eines angezeigten Querschnittsbildes das Bildsignal, das jeweils einem der angezeigten Bildpunkte entspricht, durch eine Kombination von Bildsignalen zu erzeugen, die korrespondierenden Abtastpunkten aufeinanderfolgender Abtastungen entsprechen. Dabei wird die Kombination dieser Bildsignale durch eine zeitdiskrete nichtlineare Filterung derselben durchgeführt, wobei jeder der Filterkoeffizienten in Funktion der Amplitude des Eingangssignals des Filters variabel ist, d.h. abhängig von der Amplitude des Eingangssignals wählbar vorzugeben ist.

Gegenstand der Erfindung ist somit eine Bildsignalaufbereitungsvorrichtung zur Erzeugung eines Ultraschall-Querschnittbildes eines Körpers, die in einem Ultraschall-Abbildungssystem zu verwenden ist, mit dem eine Vielzahl von aufeinanderfolgenden, sich wenigstens teilweise überdeckenden, nach den Impulsechoverfahren in einer Abtastebene zeilenweise durchgeführte Abtastungen des Körpers durchführbar sind, um Bildsignale in digitaler Form zu erzeugen, die den empfangenen Echos entsprechen, wobei jede Abtastung eine vorbestimmte Anzahl Abtastlinien und jede von diesen eine vorbestimmte Anzahl Abtastpunkte umfasst, wobei zwischen korrespondierenden Abtastpunkten aufeinanderfolgender Abtastungen ein vorbestimmtes Zeitintervall vorgesehen ist, und welches System eine Ultraschall-Abtastvorrichtung, einen damit verbundenen Sender, einen mit der Ultraschall-Abtastvorrichtung verbundenen Empfänger, einen mit dem Empfänger verbundenen Fernsehmonitor, und eine mit dem Sender, dem Empfänger, und dem Fernsehmonitor verbundene Steuereinheit enthält, wobei der Empfänger eine Detektor-Schaltung zur Erzeugung eines analogen Ausgangssignals enthält, das das jeweils empfangene Echo darstellt. Die erfindungsgemässe Bildsignalaufbereitungsvorrichtung weist hierzu im wesentlichen folgende Merkmale auf:

a) dass sie der Detektor-Schaltung des Empfängers nachgeschaltet ist, einen der Detektor-Schaltung nachgeschalteten Analog-Digital-Umsetzer, einen diesem Umsetzer nachgeschalteten digitalen Bildspeicher, einen dem Bildspeicher nachgeschalteten Digital-Analog-Umsetzer und ein nicht lineares digitales Filter enthält.

b) dass dieses Filter zwischen dem Analog-Digital-Umsetzer und dem Digital-Analog-Umsetzer eingeschaltet ist, und es wenigstens ein Verzögerungsglied enthält, mit dem eine Verzögerung des Eingangssignals des Filters durchführbar ist, deren Dauer gleich dem vorbestimmten Zeitintervall ist, das zwischen korrespondierenden Abtastpunkten aufeinanderfolgender Abtastungen vorgesehen ist, und

c) dass jeder der Filterkoeffizienten abhängig von der Amplitude des Eingangssignals des Filters variabel, d.h. vorgebbar ist.

Gegenstand der Erfindung ist ausserdem ein Ultraschall-Abbildungsgerät zur Erzeugung von Ultraschall-Querschnittbildern eines Körpers, mit welchem Gerät eine Vielzahl von aufeinanderfolgenden, sich wenigstens teilweise überdeckenden, nach dem Impulsechoverfahren in einer Abtastebene zeilenweise durchgeführten Abtastungen des Körpers durchführbar sind, um Bildsignale in digitaler Form zu erzeugen. die den empfangenen Echos entsprechen, wobei jede Abtastung eine vorbestimmte Anzahl Abtastlinien und jede von diesen eine vorbestimmte Anzahl Abtastpunkte umfasst, wobei zwischen korrespondierenden Abtastpunkten aufeinanderfolgender Abtastungen ein vorbestimmtes Zeitintervall vorgesehen ist, und welches Gerät eine Ultraschall-Abtastvorrichtung, einen damit verbundenen Sender, einen mit der Ultraschall-Abtastvorrichtung verbundenen Empfänger, einen mit dem Empfänger verbundenen Fernsehmonitor, und eine mit dem Sender, dem Empfänger, und dem Fernsehmonitor verbundene Steuereinheit enthält, wobei der Empfänger eine Detektor-Schaltung zur Erzeugung eines analogen Ausgangssignals enthält. Das erfindungsgemässe Gerät ist dadurch gekennzeichnet, dass es die oben beschriebene Bildsignalaufbereitungsvorrichtung enthält.

Die durch die Erfindung erzielten Vorteile sind im wesentlichen darin zu sehen, dass eine beachtliche Verringerung des Rauschens erzielt wird, ohne dass dabei Bewegungen im untersuchten Bereich eine Verwischung des angezeigten resultierenden Bildes verursachen. Es ist daher nun möglich geworden, gleichzeitig gut erkennbare Ultraschall-Abbildungen von bewegten Organen bzw. Organteilen (z.B. Herzklappen) zu erzeugen und die Qualität solcher Abbildungen durch Verringerung des Rauschens zu verbessern. Die Erfindung hat ferner den Vorteil, dass seine Realisierung einen relativ niedrigen Schaltungsaufwand erfordert.

Weitere Merkmale und Vorteile der Erfindung gehen aus der folgenden, anhand der beiliegenden Zeichnungen vorgenommenen Beschreibung von Ausführungsbeispielen hervor.

Es zeigen

Fig. 1 ein Blockschema eines erfindungsgemässen Ultraschall-Bildgerätes mit einem Sektorscanner.

Fig. 2 ein Blockschema eines erfindungsgemässen Ultraschall-Bildgerätes mit einem Compoundscanner.

Fig. 3 ein Blockschema der Bildsignalaufbereitungsvorrichtung 271 in Fig. 2.

Fig. 4 die Prinzipschaltung einer ersten Ausführungsform des Filters 21 in Figuren 1 und 3.

Fig. 5 die Prinzipschaltung einer zweiten Ausführungsform des Filters 21 in Fig. 1 und 3.

Fig. 6 ein Diagramm der Filterkoeffizienten für eine erste Ausführung des Filters 21 nach Fig. 4.

Fig. 7 ein Diagramm der Filterkoeffizienten für eine zweite Ausführung des Filters 21 nach Fig. 4.

Fig. 8 ein Diagramm der Filterkoeffizienten für eine Ausführung des Filters 21 nach Fig. 5.

Fig. 9 Ein Blockschema einer Schaltung, mit der wahlweise ein Filter 21 nach Fig. 4 mit den Filterkoeffizienten gemäss Fig. 6 oder gemäss Fig. 7, oder ein Filter 21 nach Fig. 5 mit den Filterkoeffizienten gemäss Fig. 8 hergestellt werden kann.

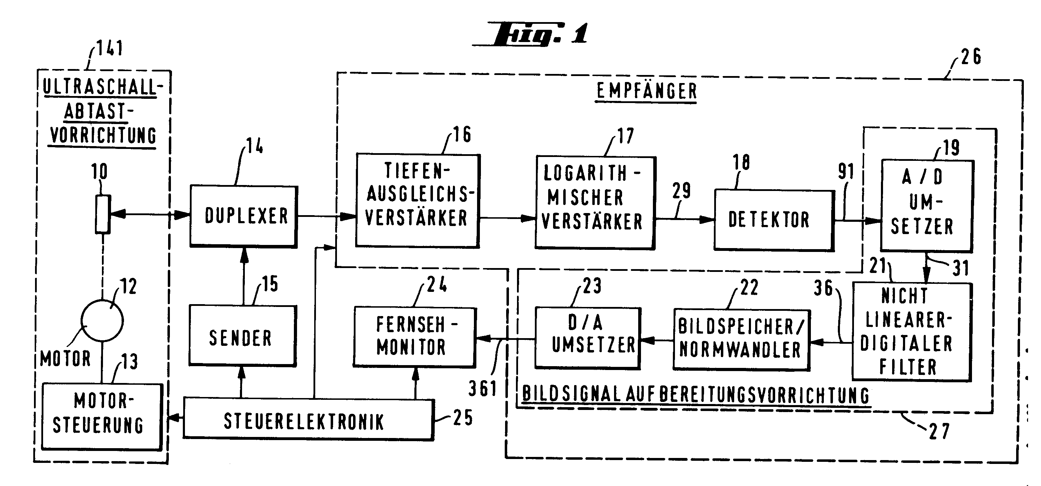

Fig. 1 zeigt das Blockdiagramm eines Ultraschall-Bildgeräts zur Durchführung des erfindungsgemässen Verfahrens.

Wie in Fig. 1 gezeigt steuert ein gepulster Sender 15 über einen Duplexer 14 einen Ultraschallwandler 10 einer Abtastvorrichtung 141 an. Diese Vorrichtung ist ein mechanischer Sektorscanner. Das empfangene Echosignal gelangt über den Duplexer 14 zum Eingang eines Empfängers 26. Der Eingang eines Tiefenausgleich-Verstärkers 16 ist zugleich der Eingang des Empfängers 26. Dem Verstärker 16 ist ein logarithmischer Verstärker 17 nachgeschaltet, der ein Ausgangssignal liefert, das über einen bestimmten Bereich proportional zum Logarithmus des Eingangssignals ist. Der Ausgang des logarithmischen Verstärkers 17 ist über eine Leitung 29 mit dem Eingang eines Detektors 18 verbunden. Mit diesem Detektor werden z.B. eine Absolutwertbildung und eine Tiefpassfilterung des Ausgangssignals des logarithmischen Verstärkers 17 durchgeführt. Das Ausgangssignal des Detektors 18 wird über eine Leitung 91 abgegeben. Dieses Signal wird in der Bildsignalaufbereitungsvorrichtung 27 mit einem Analog/Digital-Umsetzer 19 analog zu digital gewandelt. Das Ausgangssignal des Umsetzers 19 wird über eine Busleitung 31 dem Eingang eines nicht linearen digitalen Filters 21 zugeführt. Das Ausgangssignal des Filters 21 wird über eine Busleitung 36 abgegeben und in einem Bildspeicher/Normwandler 22 zwischengespeichert. Gleichzeitig wird der Inhalt des Bildspeicher/Normwandlers 22 ausgelesen. Das ausgelesene Signal wird mit einem Digital/Analog-Umsetzer 23 digital zu analog gewandelt. Das Ausgangssignal des Umsetzers 23 ist das Ausgangssignal der Bildsignalaufbereitungsvorrichtung 27. Dieses Ausgangssignal wird als Fernsehnormsignal einem Fernsehmonitor 24 zugeführt.

Der Ultraschallwandler 10 wird von einem Motor 12 bewegt, der durch eine Motorsteuerung 13 angesteuert wird. Die dargestellte Steuerelektronik 25 gibt Befehls- und Synchronisiersignale an alle andere in Fig. 1 dargestellten Blöcke.

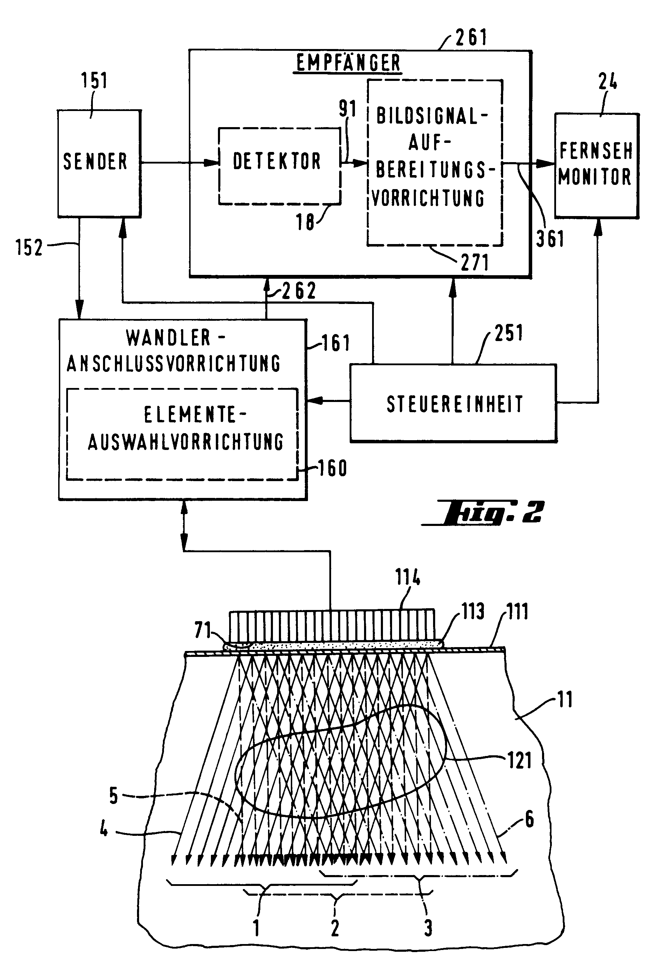

Das erfindungsgemässe Verfahren ist auch bei Ultraschallabbildungen anwendbar, bei denen die verwendeten Abtastmuster sich nur teilweise überlappen. Das erfindungsgemässe Verfahren kann daher auch mit dem in Fig. 2 durch ein Blockdiagramm dargestellten Ultraschallgerät-Bildgerät durchgeführt werden, das mit einem elektronischen Compoundscanner arbeitet.

Das Ultraschall-Bildgerät gemäss Fig. 2 enthält eine Wandleranordnung 114, eine Wandler-Anschlussvorrichtung 161, einen Sender 151, einen Empfänger 261, einen Fernsehmonitor 24 und eine Steuereinheit 251.

Die Wandleranordnung 114 enthält eine längliche Anordnung von aneinander angrenzenden Wandlerelementen. Die Wandleranordnung 114 kann eine flache Abstrahlfläche 71 haben. In einer bevorzugten Ausführungsform hat aber ihre Abstrahlfläche eine gewisse Krümmung, die eine Fokussierung der Ultraschallwellen in einer zur Abtastebene senkrechten Ebene bewirkt.

Da das Ultraschall-Bildgerät gemäss Fig. 2 mit einer segmentierten Wandleranordnung 114 arbeitet, deren Wandlerelemente gruppenweise nacheinander so angesteuert werden, das mehrere Scans mit verschiedenen Richtungswinkeln durchgeführt werden können, enthält die Wandler-Anschlussvorrichtung 161 eine Elemente-Auswahlvorrichtung 160, mit der jedes Wandlerelement der Wandleranordnung 114 wahlweise mit einem geeigneten Anschluss des Senders 151 verbunden werden kann.

Die Wandler-Anschlussvorrichtung 161 ist über je eine Busleitung 152 bzw. 262 mit dem Sender 151 bzw. mit dem Empfänger 261 verbunden.

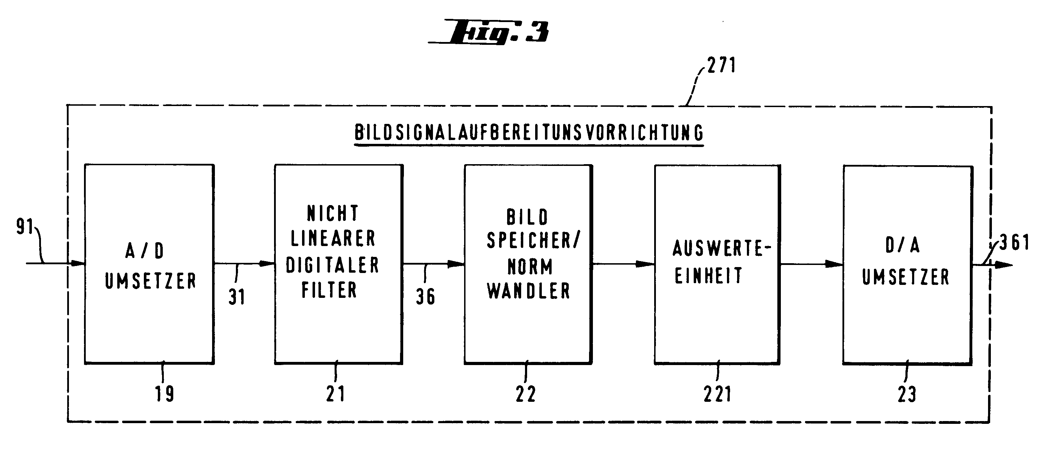

Der Empfänger 261 hat einen ähnlichen Aufbau wie der Empfänger 26 in Fig. 1, enthält aber zusätzlich in Fig. 2 nicht gezeigte Mittel zur Addition der von den einzelnen Wandlerelementen kommenden Echosignale zur Bildung eines resultierenden Echosignals. Der Empfänger 261 enthält u.a. eine Detektor-Schaltung 18 wie diejenige vom Empfänger 26 und eine Bildsignalaufbereitungsvorrichtung 271, die nachstehend anhand der Fig. 3 im Detail beschrieben ist.

Das Ausgangssignal der Detektor-Schaltung 18 wird dem Eingang der Bildsignalverarbeitungsvorrichtung 271 über eine Leitung 91 zugeführt. Die Bildsignale am Ausgang der Vorrichtung 271 werden dem Fernsehmonitor 24 über eine Leitung 361 zugeführt.

Die Steuereinheit 251 enthält die notwendigen Mittel zur Steuerung der Funktion aller anderen in Fig. 2 gezeigten Blöcke.

Im unteren Teil der Fig. 2 ist die Verwendung des dort gezeigten Bildgerätes bei der Untersuchung eines Körperteils 11 eines Patienten schematisch dargestellt. Wie in dieser Figur gezeigt, wird die Wandleranordnung 114 auf die Haut 111 des zu untersuchenden Körperteils 11 aufgesetzt, wobei ein Uebertragungsgel 113 zwischen die Abstrahlfläche der Wandlereinrichtung und die Haut des Patienten gebracht wird.

Das in Fig. 2 gezeigte Abbildungssystem wird so betrieben, dass mit der Wandleranordnung 114 wenigstens zwei verschiedene, sich teilweise überdeckende Abtastungen in der Abtastebene nach dem Impulsechoverfahren durchgeführt werden, um ein zusammengesetztes Querschnittbild, z.B. von einem internen Organ 121, zu erzeugen. Dabei werden z.B. drei solcher Abtastungen 1, 2, 3 in rascher Folge nacheinander durchgeführt. Bei jeder dieser Abtastungen werden in rascher Folge Gruppen von Wandlerelementen der Wandleranordnung 114 verwendet, die Ultraschallimpulse in eine bestimmte Richtung senden und die entsprechenden Echos empfangen. Auf diese Weise wird der untersuchte Körperteil bei jeder der Abtastungen 1, 2 bzw. 3 mit einer raschen Folge von zueinander parallelen Ultraschallstrahlen bestrahlt. In der Fig. 2 sind für jede der Abtastungen 1, 2, 3 die entsprechenden Strahlen (hier auch Abtastlinien genannt) 4, 5 bzw. 6 mit verschiedenen Linien dargestellt. Durch das soeben beschrieben Verfahren wird der untersuchte Körperteil mit dem in Fig. 1 gezeigten, zusammengesetzten Abtastmuster in sehr kurzer Zeit bestrahlt.

Im Sender 151 werden die Sendesignale für die Wandlerelemente der Wandleranordnung 114 erzeugt, und die von den Wandlerelementen gelieferten Echosignale werden dem Empfänger 261 über die Leitung 262 zugeführt. Die empfangenen Echosignale werden am Ausgang des Detektors 18 und über die Leitung 91 abgegeben.

Durch die verschiedenen, in Fig. 2 gezeigten Abtastungen 1, 2 bzw. 3 werden Einzelbilder aufgenommen. Die nachstehend im Detail beschriebene Bildsignalaufbereitungsvorrichtung 271 dient u.a. dazu, ein elektronisches Compounding, d.h. eine Zusammensetzung dieser Einzelbilder durchzuführen, um ein zusammengesetztes Bild zu erzeugen, das Compound-Bild genannt wird.

Wie in Fig. 3 durch ein Blockschema dargestellt, enthält die Bildsignalaufbereitungsvorrichtung 271 in Fig. 2 die gleichen Blöcke 19, 21, 22 und 23 wie die Vorrichtung 27 in Fig. 1 und zusätzlich eine zwischen dem Bildspeicher/Normwandler 22 und dem Digital/Analog-Umsetzer 23 eingeschaltete Auswerteeinheit 221. Diese Einheit dient dazu, die aus dem Bildspeicher/Normwandler 22 gelesenen Bildsignale zur Erzeugung des Compound-Bildes miteinander zu kombinieren, z.B. durch Mittelwertbildung der Bildsignale.

Das Ausgangssignal der Bildsignalaufbereitungsvorrichtung 271 wird über die Leitung 361 dem Fernsehmonitor zugeführt. Mit dem Fernsehmonitor 24 wird dann ein Compound-Bild angezeigt, d.h. ein Bild, das durch die oben erwähnte, elektronische Zusammensetzung von Einzelbildern erzeugt wird.

Die vorliegende Erfindung betrifft die Ausbildung der Bildsignalaufbereitungsvorrichtung 27 in Fig. 1 und 271 in Fig. 2. Diese Vorrichtung ist insbesondere dadurch gekennzeichnet, dass sie ein nicht lineares digitales Filter 21 enthält, das zwischen dem Analog/Digital-Umsetzer 19 und dem Digital/Analog-Umsetzer 23 eingeschaltet ist, und dass die Koeffizienten des Filters 21 in abhängig von der Amplitude seines Eingangssignals des Filters variabel, d.h. vorgebbar sind. In den in Figuren 1 und 2 gezeigten Schaltungen ist der Filter 21 zwischen dem Analog/Digital-Umsetzer 19 und dem Bildspeicher/Normwandler 22 eingeschaltet. Der Filter 21 kann aber auch dem Block 22 in Fig. 1 oder Fig. 2, oder dem Block 221 in Fig. 3 nachgeschaltet sein, wenn dies bei der Bestimmung der Filterkoeffizienten berücksichtigt wird.

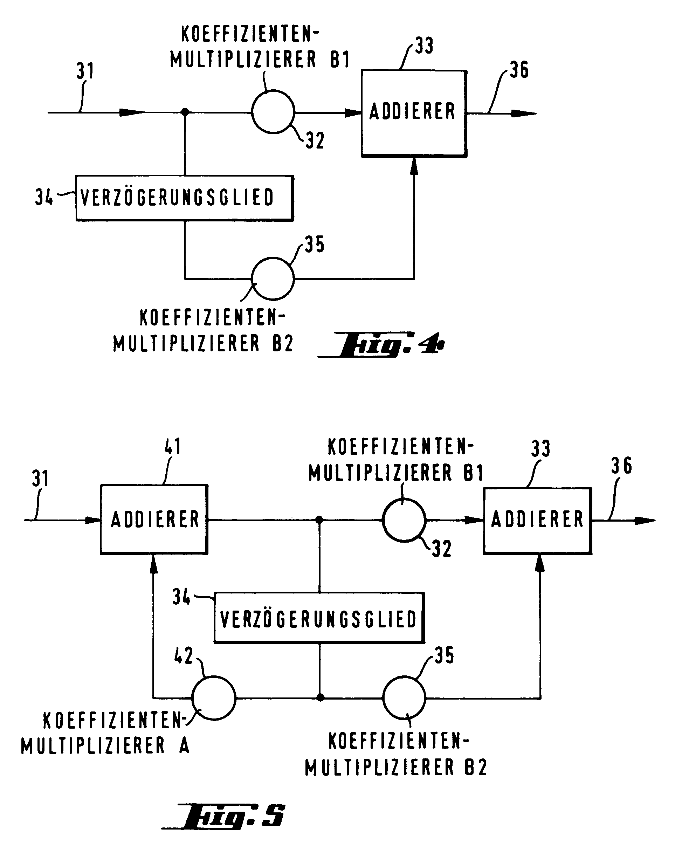

Die Prinzipschaltung einer ersten Ausführungsform des Filters 21 ist in der Fig. 4 dargestellt. Dieser Filter ist ein Transversalfilter erster Ordnung, und enthält ein Verzögerungsglied 34. Koeffizientmultiplizierer 32 und 35 und einen Addierer 33. Ueber die Busleitung 31 werden dem Eingang des Filters 21 die vom Ausgang des Analog/Digital/Umsetzers 19 gelieferten Signale zugeführt. Das Ausgangssignal des Filters 21 wird über die Leitung 36 abgegeben.

Mit dem Koeffizientenmultiplizierer 32 wird ein Koeffizient B1 und mit dem Koeffizientenmultiplizierer 35 ein Koeffizient B2 eingeführt.

Mit dem Verzögerungsglied 34 wird eine Verzögerung des Eingangssignals des Filters 21 durchgeführt, deren Dauer gleich dem vorbestimmten Zeitintervall ist, das zwischen korrespondierenden Abtastpunkten aufeinanderfolgender Abtastungen vorgesehen ist.

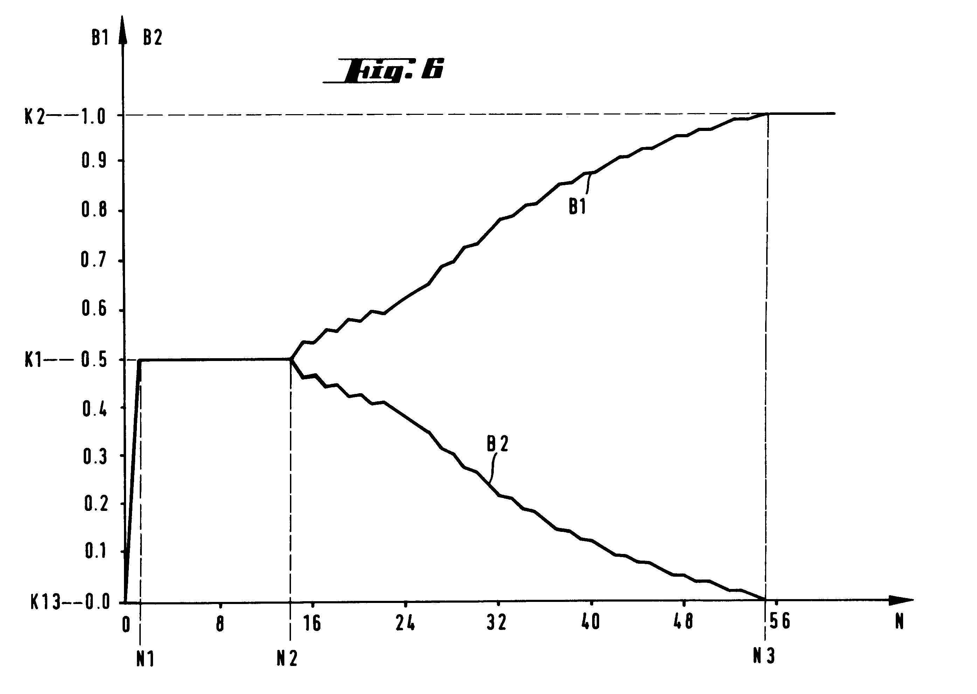

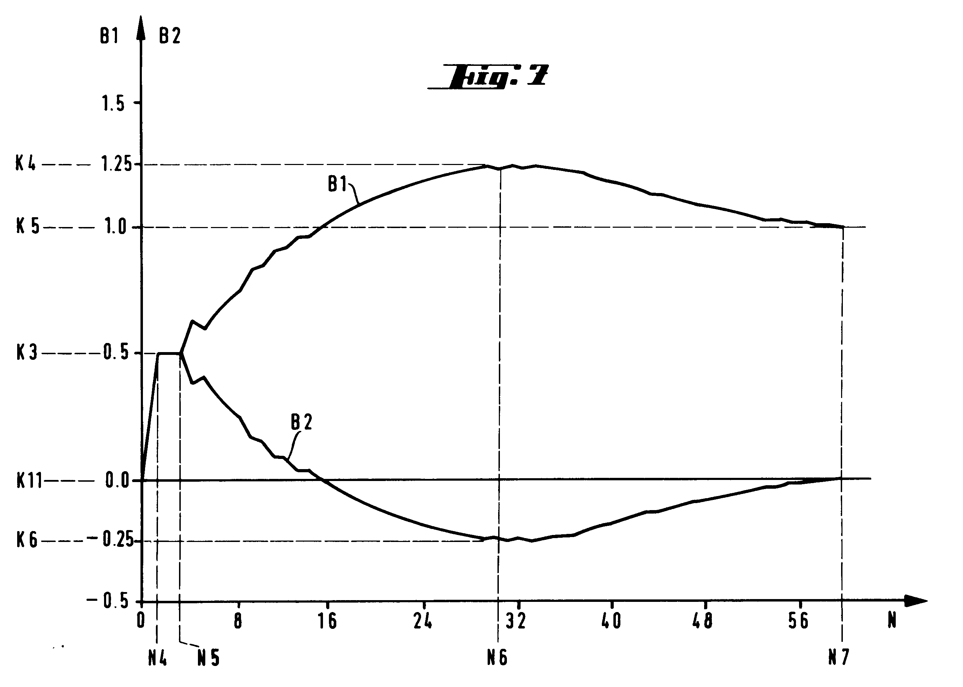

Die Koeffizientenmultiplizierer 32 und 35 sind so eingerichtet dass jeder der Filterkoeffizienten B1 bzw. B2 abhängig von der Amplitude des Eingangssignals des Filters vorgebbar variabel ist. Die Fig. 6 zeigt ein Diagramm, aus dem ein Beispiel der Variation der Filterkoeffizienten B1 und B2 in Abhängigkeit von der Amplitude N des Eingangssignals des Filters, ersichtlich ist.

Die Werte der Amplitude N des Eingangssignals des Filters liegen zwischen dem Wert N = 0, der einem schwarzen Punkt der Fernsehanzeige entspricht, und dem Wert N = 63, der einem weissen Punkt der Fernsehanzeige entspricht.

Gemäss Fig. 6 sind die Filterkoeffizienten B1 und B2 durch folgende Funktionen der Amplitude N des Eingangssignals des Filters definiert:
- für relativ niedrige Werte von N in einem Bereich von einem Wert N1 bis zu einem Wert N2 gilt: B1 = B2 = K1;
- für mittlere Werte von N in einem Bereich zwischen dem Wert N2 und einem Wert N3:
nimmt B1 vom Wert B1 = K1 ausgehend mit zunehmender N zu und erreicht den Wert B1 = K2 bei N = N3,
nimmt B2 vom Wert B2 = K1 ausgehend mit zunehmender N ab und erreicht den Wert B2 = K13 bei N = N3;
- für relativ hohe Werte von N, die gleich oder grösser als N3 sind, gilt: B1 = K2 und B2 = K13,
wobei N1, N2, N3 vorbestimmte, vorzugebende Werte der Amplitude des Eingangssignals N und K1, K2, K13 feste vorzugebende Werte sind, wie sich noch nachfolgend ergibt.

Im Beispiel gemäss Fig. 6 ist K1 = 0,5, K2 = 1,00 und K13 = 0. Im allgemeinen können auch andere Werte von K1, K2 und K13 verwendet werden. In bevorzugten Ausführungsformen ist aber der Verlauf von B1 in bezug auf den Verlauf von B2 wenigstens annähernd derselbe wie in Fig. 6 dargestellt.

Jeder der Koeffizientenmultiplizierer 32 und 35 ist z.B. ein PROM. Das Verzögerungsglied 34 ist z.B. ein als digitale Verzögerungsleitung verwendeter Bildspeicher.

Wenn der Filter 21 die Schaltung gemäss Fig. 4 hat und mit den Filterkoeffizienten gemäss Fig. 6 arbeitet, wird damit eine nicht lineare Filterung der Eingangssignale durchgeführt, welche die Wirkung hat, dass Eingangssignale, die eine relativ kleine Amplitude haben, über zwei aufeinanderfolgenden Bilder gemittelt werden, während Eingangssignale, die eine relativ grosse Amplitude haben, überhaupt nicht gemittelt werden und direkt zum Ausgang des Filters gelangen. Dadurch werden folgende Effekte erzielt:
- Eine Verwischung des angezeigten Bildes durch Mittelung von Echosignalen, die relativ grosse Amplituden haben, wird vermieden.
- Die Abbildung von Bewegungen, die im allgemeinen durch relativ grosse Echosignale vertreten sind, wird gegenüber bisher bekannten Systemen verbessert, bei denen durch eine lineare Filterung der Echosignale eine Mittelung aller Echosignale - unabhängig von ihrer Amplitude - durchgeführt wird.

EP 0 219 098 B1

- Durch die Mittelung der relativ kleinen Echosignale wird eine Verbesserung des Signal-Rauschen-Verhältnisses des resultierenden Bildes gegenüber bekannten Systemen erzielt, bei denen keine Massnahmen zur Verbesserung dieses Verhältnisses vorgesehen sind.

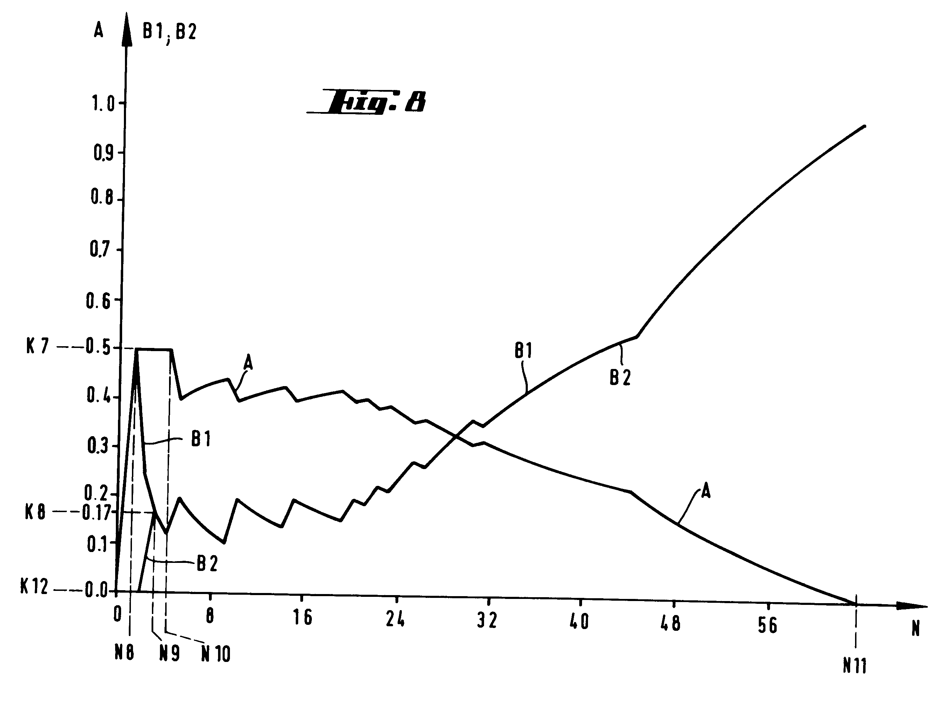

Eine zweite Ausführungsform des Filters 21 hat ebenfalls die Schaltung gemäss Fig. 4, aber arbeitet mit anderen Filterkoeffizienten. Ein Beispiel der Variation dieser Koeffizienten in Abhängigkeit von der Amplitude des Eingangssignals des Filters ist aus dem in Fig. 7 dargestellten Diagramm ersichtlich. Auch in diesem Diagramm liegen die Werte von N zwischen den oben definierten Extremwerten N = 0 und N = 63.

Gemäss Fig. 7 sind die Filterkoeffizienten B1 und B2 durch folgende Funktionen der Amplitude des Eingangssignals des Filters definiert:

- für relativ sehr niedrige Werte von N in einem Bereich von einem Wert N4 bis zu einem Wert N5 gilt: B1 = B2 = K3;
- für relativ niedrige und mittlere Werte von N in einem Bereich zwischen dem Wert N5 und einem Wert N7:

  nimmt B1 vom Wert B1 = K3 ausgehend mit zunehmender N zu, bis er bei N = N6 einen maximal Wert B1 = K4 erreicht, nimmt von dort mit zunehmender N ab, und erreicht den Wert B1 = K5 bei N = N7;

  nimmt B2 vom Wert B2 = K3 ausgehend mit zunehmender N ab, bis er bei N = N6 einen minimal Wert B2 = K6 erreicht, der kleiner als 0 ist, nimmt von dort mit zunehmender N zu, und erreicht den Wert B2 = K11 bei N = N7, wobei K11 gleich oder kleiner als 0 ist;

- für relativ hohe Werte von N, die gleich oder grösser als N7 sind, gilt: B1 = K5 und B2 = K11, wobei N4, N5, N6, N7 vorbestimmte vorzügebende Werte der Amplitude des Eingangssignals N und K3, K4, K5, K6, K11 feste vorzugebende Werte sind.

Im Beispiel gemäss Fig. 7 ist K3 = 0,5, K4 = 1,25, K5 = 1,00, K6 = -0,25 und K11 = 0. Im allgemeinen können auch andere Werte von K3, K4, K5, K6 und K7 verwendet werden, vorausgesetzt, dass K6 kleiner als 0 ist und dass K11 gleich oder kleiner als 0 ist. In bevorzugten Ausführungsformen ist aber der Verlauf von B1 in bezug auf den Verlauf von B2 wenigstens annähernd derselbe wie in Fig. 7 dargestellt.

Mit dieser zweiten Ausführungsform des Filters 21, d.h. die Ausführung mit der Schaltung gemäss Fig. 4 und die Filterkoeffizienten gemäss Fig. 7, wird ausser der bereits oben erwähnten Effekte, die mit der ersten Ausführungsform gemäss Fig. 4 und 6 erzielt werden, eine Hervorhebung der Eingangssignale erzielt, die Bewegungen im untersuchten Bereich entsprechen. Diese zweite Ausführungsform des Filters 21 hat also zusätzlich die Funktion eines Festzeichenlöschers (Moving Target Indicator).

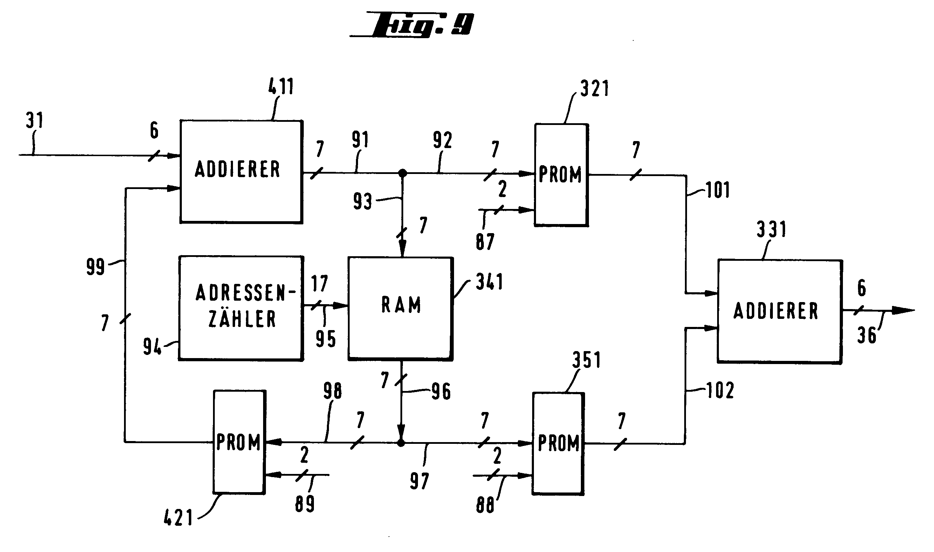

Mit den oben beschriebenen Ausführungsformen des Filters 21 können die Eingangssignale des Filters höchstens über 2 Bilder gemittelt werden. Diese Grenze kann mit einer rekursiven Filterschaltung überschritten werden, wie diejenige die in Fig. 5 dargestellt ist, wenn diese mit Filterkoeffizienten A, B1 und B2 arbeitet, die z.B. nach dem in Fig. 8 dargestellten Diagramm in Funktion der Amplitude N des Eingangssignals des Filters variieren.

Die Filterschaltung nach Fig. 5 hat eine kanonische Struktur erster Ordnung.

Die Filterschaltung gemäss Fig. 5 unterscheidet sich von derjenigen gemäss Fig. 4 lediglich darin, dass in der Schaltung gemäss Fig. 5 ein Rückkopplungspfad vorgesehen ist, in dem ein Koeffizient A mittels eines Koeffizientenmultiplizierers 42 eingeführt wird, und dass das dadurch rückgekoppelte Signal und das Eingangssignal des Filters mittels eines Addierers 41 addiert werden.

Gemäss Fig. 8 sind die Filterkoeffizienten A, B1, B2 durch folgende Abhängigkeiten von der Amplitude N des Eingangssignals des Filters definiert:

- für relativ sehr niedrige Werte von N in einem Bereich von einem sehr Kleinen Wert N8 bis zu einem dagegen grösseren Wert N10 gilt A = K7;
- für relativ niedrige und mittlere Werte von N in einem Bereich zwischen dem Wert N10 und einem dagegen grossen Wert N11:

  variiert A wie ersichtlich schwankend, nimmt aber vom Wert A = K7 ausgehend mit zunehmender N allmählich ab, bis er den Wert A = K12 bei N = N11 erreicht, wobei K12 gleich oder grösser als 0 ist:

- für relativ sehr niedrige Werte von N in einem Bereich zwischen dem Wert N8 und einem dagegen grösseren Wert N9, und für zunehmende Werte von N nimmt B1 vom Wert B1 = K7 ausgehend ab und nimmt B2 vom Wert B2 = 0 ausgehend zu, bis B1 und B2 beim Wert N = N9 einen und denselben Wert B1 = B2 = K8 erreichen;

- für Werte von N, die gleich oder grösser als N9 sind, gilt B1 = B2, wobei diese Koeffizienten wie ersichtlich schwankend variieren, aber mit zunehmender Amplitude N allmählich zunehmen, wobei N8, N9, N10, N11 vorbestimmte vorzügebende Werte der Amplitude des Eingangssignals N und K7, K8, K12 feste vorzügebende Werte sind.

Auch im Diagramm gemäss Fig. 8 liegen die Werte von N zwischen den oben definierten Extremwerten

6

N = 0 und N = 63.

Im Beispiel gemäss Fig. 8 ist K7 = 0,5, K8 = 0,17, und K12 = 0. Im allgemeinen können auch andere Werte von K7, K8 und K12 verwendet werden, vorausgesetzt, dass K7 grösser als K8, K8 grösser als K12, und dass K12 gleich oder grösser als 0 ist. In bevorzugten Ausführungsformen ist aber der Verlauf jedes der Koeffizienten A, B1 und B2 in bezug auf den Verlauf der anderen zwei Koeffizienten wenigstens annähernd derselbe wie in Fig. 8 dargestellt.

Bei der Bestimmung der Werte der Filterkoeffizienten A, B1, B2 des Filters nach Fig. 5 sind zwei Aspekte zu berücksichtigen:

- Es ist in der Regel erwünscht, dass die Filterung die Grautonverteilung eines statischen Bildes nicht ändert, d.h. dass die Filterung keine Kompression der Bildsignale verursacht. Um diese Bedingung zu erfüllen, muss die Uebertragungsfunktion des Filters H (z) für z = 1 gleich 1 sein, d.h. H (z) = 1 für z = 1. Für einen rekursiven Filter, der eine kanonische Struktur erster Ordnung hat, muss also die Bedingung erfüllt werden:

$$H\ (z)\ =\ (BI\ +\ B2.z^{-1})/(I\text{-}A.z^{-1})\ =\ I\ \text{für}\ z\ =\ I \qquad (I)$$

Daraus ergibt sich die Bedingung:

$$(BI\ +\ B2)/(I\text{-}A)\ =\ I \qquad (II)$$

Diese Bedingung (II) gilt auch für die oben beschriebenen Ausführungsbeispiele mit der Filterschaltung gemäss Fig. 4.

Wenn eine Kompression der Echosignale durchgeführt wird, muss die I auf der rechten Seite der Gleichung (II) durch eine Funktion der Amplitude N die der Kompression entspricht ersetzt werden.

- Die Filterkoeffizienten müssen ausserdem so gewählt werden, dass das Filter stabil ist. Da die Funktion A(N).N nicht monoton ist, treten Schwingungen am Eingang (und am Ausgang) des Verzögerungsgliedes 34 für gewisse Werte des Eingangssignals des Filters auf. Durch Computersimulation ist es möglich, die Funktion A(N).N so zu bestimmen, dass die Frequenz solcher Schwingungen die Hälfte der Bildfrequenz ist. Auf diese Weise hat man lediglich zwei mögliche Zustände für jeden Wert des Eingangssignals, der solche Schwingungen verursacht. Es genügt daher bei der Bestimmung der Koeffizienten BI und B2 die Bedingung

$$BI\ (N)\ =\ B2\ (N) \qquad (III)$$

zu erfüllen, damit solche Schwingungen sich durch Addition gegenseitig aufheben und am Ausgang des Filters nicht erscheinen.

Unter Berücksichtigung der oben erwähnten Bedingungen (i)-(III) geht man bei der Bestimmung der Filterkoeffizienten wie folgt vor:

Zuerst wird eine Funktion A(N) gewählt. Mit den so gewählten Werten des Koeffizienten A werden dann die Koeffizienten BI und B2 anhand der Gleichungen (II) und (III) bestimmt. Daraufhin wird geprüft, ob die Sprungantwort des Filters für jeden Wert der Amplitude N des Eingangssignals, d.h. für jede Gruppe von Werten der Koeffizienten A, BI, B2, die einem solchen Wert von N entspricht, stabil ist, und ob der Filter die Grautonverteilung eines statischen Bildes unverändert lässt. Wenn dies nicht der Fall ist, muss man das soeben beschriebene Verfahren mit einer neuen gewählten Funktion A(N) durchführen, usw.

Mit dieser dritten Ausführungsform gemäss Fig. 5 und 8 werden folgende Vorteile gegenüber der oben beschriebenen ersten und zweiten Ausführungsform erzielt: Es wird ein noch höheres Signal-Rauschen-Verhältnis bei guter, klar erkennbarer Darstellung von Bewegungen im untersuchten Bereich.

Die Fig. 9 zeigt das Blockschema einer Schaltung, mit der wahlweise ein Filter 2I nach Fig. 4 mit den Filterkoeffizienten gemäss Fig. 6 oder Fig. 7, oder ein Filter 2I nach Fig. 5 mit den Filterkoeffizienten gemäss Fig. 8 hergestellt werden kann.

Das Eingangssignal wird dem Eingang des Filters nach Fig. 9 über ein 6-Bit Busleitung 3I zugeführt. Diese Busleitung ist mit einem ersten Eingang eines Addierers 4II verbunden. Der Ausgang des Addierers 4II ist über 7-Bit Busleitungen 9I-93 mit einem ersten Adressen-Eingang eines PROM 32I und mit dem Data-Eingang eines RAM 34I verbunden. Die Funktion des RAM 34I wird von einem Adressenzähler 94 gesteuert, dessen Ausgang über eine I7-Bit Busleitung 95 mit dem Adressen-Eingang des RAM 34I verbunden ist. Der Data-Ausgang des RAM 34I ist über 7-Bit Busleitungen 96-98 mit einem ersten Adressen-Eingang eines PROM 35I und mit einem ersten Adressen-Eingang eines PROM 42I verbunden. Der Ausgang des PROM 42I ist über eine 7-Bit Busleitung 99 mit einem zweiten Eingang des Addierers 411 verbunden. Die

7

Ausgänge der PROM 321 bzw. 351 sind über je eine 7-Bit Busleitung 101 bzw. 102 mit einem ersten bzw. einem zweiten Eingang eines Addierers 331 verbunden. Das Ausgangssignal des Addierers 331 wird über eine 6-Bit Busleitung 36 abgegeben.

Die PROM 321, 351 und 421 werden als Koeffizientenmultiplizierer verwendet. Damit können wahlweise z.B. folgende Koeffizienten eingeführt werden:

| PROM | Filterkoeffizient |
|------|-------------------|
| 321 | B1 gemäss Fig. 6. 7 oder Fig. 8 |
| 351 | B2 gemäss Fig. 6, 7 oder 8 |
| 421 | A gemäss Fig. 8 oder A = 0 |

In jedem der PROM 321, 351, 421 gibt es 512 verschiedene Adressen, die über einen 9-Bit Adressenbus multiplexiert sind. In jeder Adresse kann ein Wort mit einer Wortlänge von 8-Bit gelesen werden. Gemäss der obigen Beschreibung des Blockschemas gemäss Fig. 9 werden davon nur 7 Bit verwendet. Jeder der PROM 321, 351, 421 hat einen zweiten Adressen-Eingang. Ein Steuersignal wird jedem dieser Eingänge über je eine 2-Bit Busleitung 87, 88 bzw. 89 zugeführt. Mit diesem Steuersignal wird die Gruppe von Koeffizienten gewählt, die mit jedem PROM eingeführt werden soll. Das 2-Bit Steuersignal kann 4 verschiedene Werte haben. Damit können also 4 veschiedene Gruppen von Filterkoeffizienten pro PROM und dadurch 4 verschiedene Filter gewählt werden.

In der Schaltung nach Fig. 9 hat der RAM 341 die Funktion eines Verzögerungsgliedes. Im RAM 341 sind die Speicherplätze für die Bildsignale in einer Matrix mit 256 Spalten und 512 Zeilen angeordnet. Diese Anordnung entspricht der Anordnung der abgetasteten Punkte und der Anordnung der angezeigten Bildpunkte. Jedes dort gespeicherte Bildsignal ist in Form eines 7-Bit Wortes kodiert.

Die Steuerung des RAM 34l durch den Adresszähler 94 bewirkt, dass der RAM 34l als ein Schieberegister funktioniert. Auf diese Weise hat man gleichzeitig am Eingang des RAM 34l das Bildsignal für einen abgetasteten Punkt der laufenden Abtastung und am Ausgang des RAM 34l das Bildsignal für den gleichen Punkt bei der vorhergehenden Abtastung.

**Patentansprüche**

1.  Bildsignalaufbereitungsvorrichtung (27, 271) für ein Ultaschall-Abbildungssystem zur Erzeugung eines Ultraschall-Querschnittbildes eines Körpers,

    wobei mit dem System eine Vielzahl von aufeinanderfolgenden, sich wenigstens teilweise überdeckenden und nach den Impulsechoverfahren in einer Abtastebene zeilenweise durchgeführten Abtastungen des Körpers ausgeführt werden, um Bildsignale in digitaler Form zu erzeugen, die den empfangenen Echos entsprechen, wobei jede Abtastung eine vorbestimmte Anzahl Abtastlinien und jede von diesen eine vorbestimmte Anzahl Abtastpunkte umfasst,

    wobei zwischen korrespondierenden Abtastpunkten aufeinanderfolgender Abtastungen ein vorbestimmtes Zeitintervall vorgesehen ist,

    wobei dieses System eine Ultraschall-Abtastvorrichtung (141, 114), einen damit verbundenen Sender (15, 151), einen mit der Ultraschall-Abtastvorrichtung verbundenen Empfänger (26, 261), einen mit dem Empfänger verbundenen Fernsehmonitor (24) und eine mit dem Sender, dem Empfänger und dem Fernsehmonitor verbundene Steuereinheit (25, 251) enthält,

    wobei der Empfänger eine Detektor-Schaltung (18) zur Erzeugung eines analogen Ausgangssignals enthält, das das jeweils empfangene Echo darstellt, und

    wobei die Bildsignalaufbereitungsvorrichtung (27, 271) dadurch gekennzeichnet ist,

    a) dass sie (27, 271) der Detektor-Schaltung (18) des Empfängers (26, 261) nachgeschaltet ist und einen der Detektor-Schaltung (18) nachgeschalteten Analog-Digital-Umsetzer (19), einen diesem Umsetzer nachgeschalteten digitalen Bildspeicher (22), einen dem Bildspeicher nachgeschalteten Digital-Analog-Umsetzer (23) und ein nichtlineares digitales Filter (21) enthält, das die Struktur eines transversalen Filters hat,

    b) dass dieses Filter (21) zwischen dem Analog-Digital-Umsetzer (19) und dem Digital-Analog-Umsetzer (23) eingeschaltet ist und es einen Addierer (33), wenigstens ein Verzögerungsglied (34), mit dem eine Verzögerung des Eingangssignals des Filters durchführbar ist, deren Dauer gleich dem vorbestimmten Zeitintervall ist, das zwischen korrespondierenden Abtastpunkten aufeinanderfolgender Abtastungen vorgesehen ist, und zwei Koeffizientenmultiplizierer (32, 35), einen in einem unverzögerten und einen in dem verzögerten Signalweg eingefügt, für Filterkoeffizienten $B_1$ und $B_2$

enthält (Fig. 4) und

c) dass der Filterkoeffizient B1 für im Filter (21) nicht verzögerte Eingangssignale und der Filterkoeffizient B2 für im Filter verzögerte Eingangssignale durch folgende Vorgaben, abhängig von der Amplitude N des Eingangssignals des Filters, definiert sind:

- für relativ niedrige Werte von N in einem Bereich von einem Wert N1 bis zu einem Wert N2 gilt: B1 = B2 = K1;
- für mittlere Werte von N in einem Bereich zwischen dem Wert N2 und einem Wert N3:

    nimmt B1 vom Wert B1 = K1 ausgehend mit zunehmender Amplitude N zu und erreicht den Wert B1 = K2 bei N = N3,

    nimmt B2 vom Wert B2 = K1 ausgehend mit zunehmender Amplitude N ab und erreicht den Wert B2 = K13 bei N = N3;

- für relativ hohe Werte von N die gleich oder grösser als der Wert N3 sind, gilt: B1 = K2 und B2 = K13,

    wobei N1, N2, N3 für den Einzelfall vorzugebende Werte der Amplitude N des Eingangssignals und K1, K2, K13 derart vorzugebende Werte sind, dass einerseits für Bildpunkte mit relativ grosser Amplitude Verwischungen vermieden und die Abbildung von Bewegungen verbessert sind und andererseits Bildpunkte mit relativ kleiner Amplitude durch die Mittelung aus dem Rauschen herausgehoben sind (Fig. 6).

2. Bildsignalaufbereitungsvorrichtung (27, 271) für ein Ultaschall-Abbildungssystem zur Erzeugung eines Ultraschall-Querschnittbildes eines Körpers,

wobei mit dem System eine Vielzahl von aufeinanderfolgenden, sich wenigstens teilweise überdeckenden und nach den Impulsechoverfahren in einer Abtastebene zeilenweise durchgeführten Abtastungen des Körpers ausgeführt werden, um Bildsignale in digitaler Form zu erzeugen, die den empfangenen Echos entsprechen, wobei jede Abtastung eine vorbestimmte Anzahl Abtastlinien und jede von diesen eine vorbestimmte Anzahl Abtastpunkte umfasst,

wobei zwischen korrespondierenden Abtastpunkten aufeinanderfolgender Abtastungen ein vorbestimmtes Zeitintervall vorgesehen ist,

wobei dieses System eine Ultraschall-Abtastvorrichtung (141, 114), einen damit verbundenen Sender (15, 151), einen mit der Ultraschall-Abtastvorrichtung verbundenen Empfänger (26, 261), einen mit dem Empfänger verbundenen Fernsehmonitor (24), und eine mit dem Sender, dem Empfänger und dem Fernsehmonitor verbundene Steuereinheit (25, 251) enthält,

wobei der Empfänger eine Detektor-Schaltung (18) zur Erzeugung eines analogen Ausgangssignals enthält, das das jeweils empfangene Echo darstellt, und

wobei die Bildsignalaufbereitungsvorrichtung (27, 271) dadurch gekennzeichnet ist,

a) dass sie (27, 271) der Detektor-Schaltung (18) des Empfängers (26, 261) nachgeschaltet ist und einen der Detektor-Schaltung (18) nachgeschalteten Analog-Digital-Umsetzer (19), einen diesem Umsetzer nachgeschalteten digitalen Bildspeicher (22), einen dem Bildspeicher nachgeschalteten Digital-Analog-Umsetzer (23) und ein nichtlineares digitales Filter (21) enthält, das die Struktur eines transversalen Filters hat,

b) dass dieses Filter (21) zwischen dem Analog-Digital-Umsetzer (19) und dem Digital-Analog-Umsetzer (23) eingeschaltet ist und es einen Addierer (33), wenigstens ein Verzögerungsglied (34), mit dem eine Verzögerung des Eingangssignals des Filters durchführbar ist, deren Dauer gleich dem vorbestimmten Zeitintervall ist, das zwischen korrespondierenden Abtastpunkten aufeinanderfolgender Abtastungen vorgesehen ist, und Zwei Koeffizientenmultiplizierer (32, 35), einen in einem unverzögerten und einen in dem verzögerten Signalweg eingefügt, für Filterkoeffizienten B1 und B2 enthält (Fig. 4), und

c) dass der Filterkoeffizient B1 für im Filter (21) nicht verzögerte Eingangssignale und der Filterkoeffizient B2 für im Filter verzögerte Eingangssignale durch folgende Vorgaben, abhängig von der Amplitude N des Eingangssignals des Filters, definiert sind:

- für relativ sehr niedrige Werte von N in einem Bereich von einem Wert N4 bis zu einem Wert N5 gilt: B1 = B2 = K3;
- für relativ niedrige und mittlere Werte von N in einem Bereich zwischen dem Wert N5 und einem Wert N7:

    nimmt B1 vom Wert B1 = K3 ausgehend mit zunehmender Amplitude N zu, bis er bei N = N6 einen Maximalwert B1 = K4 erreicht, nimmt von dort mit zunehmender Amplitude N ab, und erreicht den Wert B1 = K5 bei N = N7;

    nimmt B2 vom Wert B2 = K3 ausgehend mit zunehmender N ab, bis er bei N = N6 einen Minimalwert B2 = K6 erreicht, der kleiner als 0 ist, nimmt von dort mit zunehmender Amplitude N zu, und erreicht den Wert B2 = K11 bei N = N7, wobei K11 gleich oder kleiner als 0 ist;

- für relativ hohe Werte von N, die gleich oder grösser als N7 sind, gilt: B1 = K5 und B2 = K11,

wobei N4, N5, N6, N7 für den Einzelfall vorzugebende Werte der Amplitude N des Eingangssignals und K3, K4, K5, K6, K11 derart vorzugebende Werte sind, dass einerseits für Bildpunkte mit relativ grosser Amplitude Verwischungen vermieden und die Abbildung von Bewegungen verbessert sind und andererseits Bildpunkte mit relativ kleiner Amplitude durch die Mittelung aus dem Rauschen herausgehoben sind und desweiteren Eingangssignale hervorgehoben sind, die im Gegensatz zu Festzeichen vorliegenden Bewegungen im untersuchten Bereich entsprechen (Fig. 7).

3. Bildsignalaufbereitungsvorrichtung (27, 271) für ein Ultaschall-Abbildungssystem zur Erzeugung eines Ultraschall-Querschnittbildes eines Körpers,

wobei mit dem System eine Vielzahl von aufeinanderfolgenden, sich wenigstens teilweise überdeckenden und nach den Impulsechoverfahren in einer Abtastebene zeilenweise durchgeführten Abtastungen des Körpers ausgeführt werden, um Bildsignale in digitaler Form zu erzeugen, die den empfangenen Echos entsprechen, wobei jede Abtastung eine vorbestimmte Anzahl Abtastlinien und jede von diesen eine vorbestimmte Anzahl Abtastpunkte umfasst,

wobei zwischen korrespondierenden Abtastpunkten aufeinanderfolgender Abtastungen ein vorbestimmtes Zeitintervall vorgesehen ist,

wobei dieses System eine Ultraschall-Abtastvorrichtung (141, 114), einen damit verbundenen Sender (15, 151), einen mit der Ultraschall-Abtastvorrichtung verbundenen Empfänger (26, 261), einen mit dem Empfänger verbundenen Fernsehmonitor (24) und eine mit dem Sender, dem Empfänger und dem Fernsehmonitor verbundene Steuereinheit (25, 251) enthält,

wobei der Empfänger eine Detektor-Schaltung (18) zur Erzeugung eines analogen Ausgangssignals enthält, das das jeweils empfangene Echo darstellt, und

wobei die Bildsignalaufbereitungsvorrichtung (27, 271) dadurch gekennzeichnet ist,

a) dass sie (27, 271) der Detektor-Schaltung (18) des Empfängers (26, 261) nachgeschaltet ist und einen der Detektor-Schaltung (18) nachgeschalteten Analog-Digital-Umsetzer (19), einen diesem Umsetzer nachgeschalteten digitalen Bildspeicher (22), einen dem Bildspeicher nachgeschalteten Digital-Analog-Umsetzer (23) und ein nichtlineares digitales Filter (21) enthält, das die Struktur eines rekursiven Filters hat,

b) dass dieses Filter (21) zwischen dem Analog-Digital-Umsetzer (19) und dem Digital-Analog-Umsetzer (23) eingeschaltet ist und es zwei Addierer (33, 41), wenigstens ein Verzögerungsglied (34), mit dem eine Verzögerung des Eingangsssignals des Filters durchführbar ist, deren Daver gleich dem vorbestimmten Zeitintervall ist, das zwischen korrespondierenden Abtastpunkten aufeinanderfolgender Abtastungen vorgesehen ist, und drei Koeffizientenmultiplizierer (32,35,42) für Filterkoeffizienten B1 und B2 und Rückkopplungskoeffizienten A enthält (Fig. 5) und

c) dass der Rückkopplungskoeffizient A des im Rückkopplungsweg eingefügten Koeffizientenmultiplizierers (42), der Filterkoeffizient B1 des im Filter im nichtverzögerten Signalweg eingefügten Koeffizientenmultiplizierers (32) für im Filter nicht verzögerte Eingangssignale und der Filterkoeffizient B2 des im Filter im verzögerten Signalweg eingefügten Koeffizientenmultiplizierers (35) für im Filter verzögerte Eingangssignale durch folgende Vorgaben, abhängig von der Amplitude N des Eingangssignals des Filters, definiert sind:

- für relativ sehr niedrige Werte von N in einem Bereich von einem sehr kleinen Wert N8 bis zu einem dagegen grösseren Wert N10 gilt A = K7;
- für relativ niedrige und mittlere Werte von N in einem Bereich zwischen dem Wert N10 und einem dagegen grossen Wert N11:

nimmt der Koeffizient A sich nichtmonoton ändernd vom Wert A = K7 ausgehend mit zunehmender Amplitude N allmählich ab, bis er den Wert A = K12 bei N = N11 erreicht, wobei K12 gleich oder grösser als 0 ist;

- für relativ sehr niedrige Werte von N in einem Bereich zwischen dem sehr kleinen Wert N8 und einem dagegen größeren Wert N9 und für zunehmende Werte von N nimmt B1 vom Wert B1 = K7 ausgehend ab und nimmt B2 vom Wert B2 = 0 ausgehend zu, bis B1 und B2 beim Wert N = N9 denselben Wert K8 erreichen;
- für Werte von N, die gleich oder grösser als N9 sind, gilt B1 = B2, wobei diese Koeffizienten sich nichtmonoton ändernd mit zunehmender Amplitude N allmählich zunehmen und

wobei N8, N9, N10 für den Einzelfall vorzugebende Werte der Amplitude N des Eingangssignals und K7, K8, K12 derart vorzugebende Werte sind, dass bei verbessertem Signal-/Rauschverhältnis dennoch einerseits für Bildpunkte mit relativ grosser Amplitude Verwischungen vermieden und die Abbildung von Bewegungen verbessert sind und andererseits Bildpunkte mit relativ kleiner Amplitude durch die Mittelung aus dem Rauschen herausgehoben sind und des weiteren Eingangssignale hervorgehoben sind, die im Gegensatz zu Festzeichen Körperbewegungen im untersuchten Bereich entsprechen (Fig. 8).

4. Ultraschall-Abbildungsgerät zur Erzeugung von Ultraschall-Querschnittbildern eines Körpers, mit welchem Gerät eine Vielzahl von aufeinanderfolgenden, sich wenigstens teilweise überdeckenden, nach dem Impulsechoverfahren in einer Abtastebene zeilenweise durchgeführten Abtastungen des Körpers durchführbar sind, um Bildsignale in digitaler Form zu erzeugen, die den empfangenen Echos entsprechen.

wobei jede Abtastung eine vorbestimmte Anzahl Abtastlinien und jede von diesen eine vorbestimmte Anzahl Abtastpunkte umfasst, wobei zwischen korrespondierenden Abtastpunkten aufeinanderfolgender Abtastungen ein vorbestimmtes Zeitintervall vorgesehen ist, und

welches Gerät eine Ultraschall-Abtastvorrichtung (141, 114), einen damit verbundenen Sender (15, 151), einen mit der Ultraschall-Abtastvorrichtung verbundenen Empfänger (26, 261), einen mit dem Empfänger verbundenen Fernsehmonitor (24), und eine mit dem Sender, dem Empfänger, und dem Fernsehmonitor verbundene Steuereinheit (25, 251) enthält,

wobei der Empfänger (26, 261) eine Detektor-Schaltung (18) zur Erzeugung eines analogen Ausgangssignals enthält, das das jeweils empfangene Echo darstellt, dadurch gekennzeichnet, dass

der Empfänger eine Bildsignalaufbereitungsvorrichtung (27, 271) nach einem der Ansprüche 1-3 enthält.

## Claims

1. A video signal processing device (27, 271) for an ultrasonic imaging system for generation of a cross-sectional ultrasonic picture of a body,

whereby with the system, multiple, consecutive, at least partially overlapping body scans can be carried out line-by-line in a scanning plane and by the pulse echo method in order to generate video signals in digital form corresponding to the echoes received, whereby each scan comprises a predetermined number of action lines and each of the latter comprises a predetermined number of action spots,

whereby a predetermined time interval is provided between corresponding action spots of consecutive scans, whereby this system includes an ultrasonic scanning device (141, 114), a transmitter connected thereto (15, 151), a receiver (26, 261) connected to the ultrasonic scanning device, a television monitor (24) connected to the receiver and a control unit (25, 251) connected to the receiver and to the television monitor,

whereby the receiver includes a detector circuit (18) for generation of an analog output signal representing the echo received at any given time, and

whereby the video signal processing device (27, 271) is characterised

a) in that it (27, 271) is connected on the output side of the detector circuit (18) of the receiver (26, 261) and includes an analog-to-digital converter (19) connected on the output side of the detector circuit (18), a digital matrix memory (22) connected on the output side of the said converter, a digital-to-analog converter (23) connected on the output side of the matrix memory and a non-linear digital filter (21) having the structure of a transversal filter,

b) in that this filter (21) is inserted between the analog-to-digital converter (19) and the digital-to-analog converter (23) and that it contains an adder (33), at least one delay element (34) by means of which delay of the filter input signal can be effected, for a duration equal to the predetermined time interval provided between corresponding action spots of consecutive scans, and two coefficient multipliers (32, 35), one inserted in a undelayed and one in a delayed signal path, for filter coefficients B1 and B2 (Fig. 4) and

c) in that the filter coefficient B1 is defined for undelayed input signals in the filter (21), and filter coefficient B2 is defined for delayed input signals in the filter by the following presettings, dependent on the amplitude N of the filter input signal:

- for relatively low values of N in a range from a value N1 up to a value N2: B1 = B2 = K1
- for mean values of N in a range between the value N2 and a value N3:

B1 increases from a value B1 = K1 starting with increasing amplitude N and reaches the value B1 = K2 when N = N3,

B2 decreases from a value B2 = K1 starting with increasing amplitude N and reaches the value B2 = K13 when N = N3;

- for relatively high values of N which are equal to or greater than the value N3: B1 = K2 and B2 = K3,

where N1, N2, N3 are values of the amplitude N of the input signal to be preset in the individual case and K1, K2, K13 are values to be preset in such a way that on the one hand blurring is avoided for action spots with relatively high amplitude and imaging of movements is improved, and on the other hand, action spots with relatively low amplitude are enhanced from out of noise by averaging (Fig. 6).

2. A video signal processing device (27, 271) for an ultrasonic imaging system for generation of a cross-sectional ultrasonic picture of a body,

whereby with the system, multiple, consecutive, at least partly overlapping body scans are carried out line-by-line in a Scanning plane and by the pulse echo method, in order to generate video signals in digital form corresponding to the echoes received, whereby each scan comprises a predetermined number of action lines and each of the latter comprises a predetermined number of action spots, whereby a predetermined time interval is provided between corresponding action spots of consecutive scans,

whereby this system includes an ultrasonic scanning device (141, 114), a transmitter (15, 151) connected thereto, a receiver (26, 261) connected to the ultrasonic scanning device, a television monitor (24) connected to the receiver, and a control unit (25, 251) connected to the receiver and to the television monitor,

whereby the receiver includes a detector circuit (18) for generation of an analog output signal which represents the echo received at any given time, and

whereby the video signal processing device (27, 271) is characterised

a) in that it (27, 271) is connected on the output side of the detector circuit (18) of the receiver (26, 261) and includes an analog-to-digital converter (19) connected on the output side of the detector circuit (18), a digital matrix memory (22) connected on the output side of the said converter, a digital-to-analog converter (23) connected on the output side of the matrix memory and a non-linear digital filter (21) which has the structure of a transversal filter,

b) in that this filter (21) is inserted between the analog-to-digital converter (19) and the digital-to-analog converter (23) and that it includes an adder (33), at least one delay element (34) by which a delay of the filter input signal can be effected for duration equal to the predetermined time interval provided between corresponding action spots of consecutive scans, and two coefficient multipliers (32, 35), one in an undelayed signal path and one in a delayed signal path, for filter coefficients B1 and B2 (Fig. 4), and

c) in that the filter coefficient B1 is defined for undelayed input signals in the filter (21), and filter coefficient B2 is defined for delayed input signals in the filter by the following presettings, dependent on the amplitude N of the filter input signal:

- for relatively very low values of N in a range from a value N4 to a value N5: B1 = B2 = K3;
- for relatively low and average values of N in a range between the value N5 and a value N7:

B1 increases from a value B1 = K3 starting with increasing amplitude N until it reaches a maximum value B1 = K4 when N = N6, from whence it decreases with increasing amplitude N and reaches the value B1 = K5 when N = N7;

B2 decreases from the value B2 = K3 starting with increasing N until it reaches a minimum value B2 = K6 which is smaller than 0 when N = N6, from whence it increases with increasing amplitude N and reaches the value B2 = K11 when N = N7, where K11 is equal to or smaller than 0;

- for relatively high values of N which are equal to or greater than N7: B1 = K5 and B2 = K11,

when N4, N5, N6, N7 are values of the amplitude N of the input signal to be preset in the individual case, and K3, K4, K5, K6, K11 are values to be preset in such a way that on the one hand blurring is avoided for elements with relatively high amplitude and imaging of movements is improved, and on the other hand, picture elements with relatively low amplitude are enhanced from out of noise by averaging, and in addition, input signals are enhanced which in contrast to permanent echoes, correspond to movements present in the area under examination (Fig. 7).

3. A video signal processing device (27, 271) for an ultrasonic imaging system for generation of a cross-sectional ultrasonic picture of a body,

whereby with the system, multiple, consecutive, at least partially overlapping body scans are carried out line-by-line in a scanning plane and by the pulse echo method, in order to generate video signals in digital form corresponding to the echoes received, whereby each scan comprises a predetermined number of action lines and each of the latter comprises a predetermined number of action spots, whereby a predetermined time interval is provided between corresponding action spots of consecutive scans,

whereby this system is connected to an ultrasonic scanning device (141, 114), includes a transmitter (15, 151) connected thereto, a receiver (26, 261) connected to the ultrasonic scanning device, a television monitor (24) connected to the receiver and a control unit (25, 251) connected to the transmitter, to the receiver and to the television monitor,

whereby the receiver includes a detector circuit (18) for generation of an analog output signal representing the echo received at any given time, and

whereby the video signal processing device (27, 271) is characterised

a) in that it (27, 271) is connected on the output side of the detector circuit (18) of the receiver (26, 261) and includes an analog-to-digital converter (19) connected on the output side of the detector circuit (18), a digital matrix memory (22) connected on the output side of this converter, a digital-to-analog converter (23) connected on the output side of the matrix memory and a non-linear digital filter (21) which has the structure of a recursive filter,

b) in that this filter (21) is inserted between the analog-to-digital converter (19) and the digital-to-analog converter (23) and that it includes two adders (33, 41), at least one delay element (34) by which a delay of the filter input signal can be effected having a duration equal to the predetermined time interval which is provided between corresponding action spots of consecutive scans, and three coefficient multipliers (32, 35, 42) for filter coefficients B1 and B2 and feedback coefficients A (Fig. 5), and

c) that the feedback coefficient A of the coefficient multiplier (42) inserted in the feedback path, the filter coefficient B1 of the coefficient multiplier (32) inserted in the filter in the undelayed signal path for undelayed input signals in the filter and the filter coefficient B2 of the coefficient multiplier (35) inserted in the filter in the delayed signal path for input signals delayed in the filter are defined by the following presettings, dependent on the amplitude N of the filter input signal:

- for relatively very low values of N in a range from a very small value N8 to a comparatively fairly large value N10: $A = K7$;
- for relatively low and average values of N in a range between the value N10 and a comparatively large value N11:

    the coefficient A gradually decreases whilst changing in non-monotonic form from the value $A = K7$ starting with increasing amplitude N until it reaches the value $A = K12$ when $N = N11$, where K12 is equal to or greater than 0;

- for relatively very low values of N in a range between the very low value N8 and a comparatively larger value N9 and for increasing values of N, B1 decreases starting from the value $B1 = K7$ and B2 increases starting from the value $B2 = 0$ until B1 and B2 reach the same value K8 at a value of $N = N9$;

- for values of N which are equal to or greater than N9: $B1 = B2$, when these coefficients gradually increase whilst changing in non-monotonic form with increasing amplitude N and

    where N8, N9, N10 are values to be preset of the amplitude N of the input signal and K7, K8, K12 are values to be preset in such a way that with an improved signal-noise ratio, nevertheless blurring is on the one hand avoided for picture elements with relatively high amplitude, and imaging of movements is improved, and on the other hand picture elements with relatively small amplitude are enhanced from out of noise by averaging and, in addition, input signals are enhanced which, in contrast to permanent echoes, correspond to body movements in the area under examination (Fig. 8).

4. An ultrasonic imaging device for generation of cross-sectional ultrasonic pictures of a body, by which device multiple, consecutive, at least partially overlapping body scans can be carried out line-by-line in a scanning plane by the pulse echo method, in order to generate video signals in digital form corresponding to echoes received,

whereby each scan comprises a predetermined number of action lines and each of the latter comprises a predetermined number of action spots, whereby a predetermined time interval is provided between corresponding action spots of consecutive scans, and

which device includes an ultrasonic scanning device (141, 114), a transmitter (15, 151) connected thereto, a receiver (26, 261) connected to the ultrasonic scanning device, a television monitor (24) connected to the receiver and a control unit (25, 251) connected to the transmitter, receiver and television monitor,

whereby the receiver (26, 261) includes a detector circuit (18) for generation of an analog output signal which represents the echo received at any given time, characterised in that

the receiver includes a video signal processing device (27, 271) in accordance with one of claims 1 - 3.

**Revendications**

1.  Dispositif (27, 271) de préparation de signaux d'image destiné à un système de représentation ultrasonique pour engendrer une image ultrasonique en coupe transversale d'un corps,

    plusieurs détections successives du corps qui se recouvrent partiellement et sont exécutées par lignes selon le procédé d'écho d'impulsion dans un plan de détection étant exécutées à l'aide du système afin d'engendrer des signaux d'image sous forme numérique qui correspondent aux échos reçus, chaque détection comprenant un nombre prédéterminé de lignes de détection et chacune de celles-ci comprenant un nombre prédéterminé de points de détection, un intervalle de temps prédéterminé étant prévu entre des détections successives de points de détection correspondants,

    ce système comprenant un dispositif ultrasonique de détection (141, 114), un émetteur (15, 151) qui lui est relié, un récepteur (26, 261) relié au dispositif de détection ultrasonique, un moniteur de télévision (24) relié au récepteur et une unité de commande (25, 251) reliée à l'émetteur, au récepteur et au moniteur de télévision,

    le récepteur comprenant un circuit détecteur (18) pour engendrer un signal analogique de sortie qui représente respectivement l'écho reçu, et

    le dispositif (27, 271) de préparation de signaux d'image étant caractérisé,

    a) en ce qu'il (27, 271) est monté en aval du circuit détecteur (18) du récepteur (26, 261) et contient un convertisseur analogique à numérique (19) monté en aval du circuit détecteur (18), une mémoire numérique d'image (22) montée en aval de ce convertisseur, un convertisseur numérique à analogique (23) monté en aval de la mémoire d'image, et un filtre numérique non linéaire (21), qui possède la structure d'un filtre transversal,

    b) en ce que ce filtre (21) est monté entre le convertisseur analogique à numérique (19) et le convertisseur numérique à analogique (23) et contient un additionneur (33), au moins un élément de retard (34) grâce auquel peut être introduit un retard du signal d'entrée du filtre dont la durée est égale à l'intervalle de temps prédéterminé qui est prévu entre deux détections successives de points de détection correspondants, et deux multiplicateurs (32, 35) à coefficients, introduits l'un dans le trajet non retardé de signaux et l'autre dans le trajet retardé de signaux, pour des coefficients de filtre B1 et B2 (Fig. 4) et

    c) en ce que le coefficient B1 de filtre destiné aux signaux d'entrée non retardés dans le filtre et le coefficient B2 de filtre destiné à des signaux retardés dans le filtre sont définis par les conditions suivantes, en fonction de l'amplitude N du signal d'entrée du filtre:

    - pour des valeurs relativement faibles de N dans une zone comprise entre une valeur N1 et une valeur N2: B1 = B2 = K1
    - pour des valeurs moyennes de N dans une zone comprise entre la valeur N2 et une valeur N3;
        B1 augmente à partir d'une valeur B1 = K1 lorsque l'amplitude N augmente et atteint, pour N = N3, la valeur B1 = K2,
        B2 diminue à partir de la valeur B2 = K1 lorsque l'amplitude N augmente et atteint, pour N = N3, la valeur B2 = K13
    - pour des valeurs relativement élevées de N qui sont égales ou supérieures à la valeur N3, B1 = K2 et B2 = K13,
        N1, N2, N3 étant des valeurs de l'amplitude N du signal d'entrée à prédéterminer pour le cas particulier et K1, K2, K13 étant des valeurs à prédéterminer de telle manière que, d'une part, on évite des brouillages et la représentation de déplacement est améliorée pour des points d'image d'amplitude relativement importante, et que, d'autre part des points d'image d'amplitude relativement faible sont sortis du bruit à l'aide du processus (Fig 6).

2.  Dispositif (27, 271) de préparation de signaux d'image destiné à un système de représentation ultrasonique pour engendrer une image ultrasonique en coupe transversale d'un corps,

    plusieurs détections successives du corps qui se recouvrent partiellement et sont exécutées par lignes selon le procédé d'écho d'impulsion dans un plan de détection étant exécutées à l'aide du système afin d'engendrer des signaux d'image sous forme numérique qui correspondent aux échos reçus, chaque détection comprenant un nombre prédéterminé de lignes de détection et chacune de celles-ci comprenant un nombre prédéterminé de points de détection, un intervalle de temps prédéterminé étant prévu entre des détections successives de points de détection correspondants,

ce système comprenant un dispositif ultrasonique de détection (141, 114), un émetteur (15, 151) qui lui est relié, un récepteur (26, 261) relié au dispositif de détection ultrasonique, un moniteur de télévision (24) relié au récepteur et une unité de commande (25, 251) reliée à l'émetteur, au récepteur et au moniteur de télévision,

le récepteur comprenant un circuit détecteur (18) pour engendrer un signal analogique de sortie qui représente respectivement l'écho reçu, et

le dispositif (27, 271) de préparation de signaux d'image étant caractérisé,

a) en ce qu'il (27, 271) est monté en aval du circuit détecteur (18) du récepteur (26, 261) et contient un convertisseur analogique à numérique (19) monté en aval du circuit détecteur (18), une mémoire numérique d'image (22) montée en aval de ce convertisseur, un convertisseur numérique à analogique (23) monté en aval de la mémoire d'image, et un filtre numérique non linéaire (21), qui possède la structure d'un filtre transversal,

b) en ce que ce filtre (21) est monté entre le convertisseur analogique à numérique (19) et le convertisseur numérique à analogique (23) et contient un additionneur (33), au moins un élément de retard (34) grâce auquel peut être introduit un retard du signal d'entrée du filtre dont la durée est égale à l'intervalle de temps prédéterminé qui est prévu entre deux détections successives de points de détection correspondants, et deux multiplicateurs (32, 35) à coefficients, introduits l'un dans le trajet non retardé de signaux et l'autre dans le trajet retardé de signaux, pour des coefficients de filtre B1 et B2 (Fig. 4) et

c) en ce que le coefficient B1 de filtre destiné aux signaux d'entrée non retardés dans le filtre et le coefficient B2 de filtre destiné à des signaux retardés dans le filtre sont définis par les conditions suivantes, en fonction de l'amplitude N du signal d'entrée du filtre:

- pour des valeurs relativement très faibles de N dans une zone comprise entre une valeur N4 et une valeur N5, B1 = B2 = K3

- pour des valeurs relativement faibles et moyennes de N dans une zone comprise entre la valeur N5 et une valeur N7:

B1 augmente à partir de la valeur B1 = K3 lorsque l'amplitude N augmente, jusqu'à ce qu'il atteigne, pour N = N6, une valeur maximale B1 = K4, diminue à partir de là lorsque l'amplitude N augmente et atteint, pour N = N7, la valeur B1 = K5;

B2 diminue à partir de la valeur B2 = K3 lorsque N augmente, jusqu'à ce qu'il atteigne, pour N = N6, une valeur minimale B2 = K6 qui est plus petite que 0, augmente à partir de là lorsque l'amplitude N augmente et atteint, pour N = N7, la valeur B2 = K11, K11 étant égal ou plus petit que 0;

- pour des valeurs relativement élevées de N qui sont égales ou supérieures à N7, B1 = K5 et B2 = K11,

N4, N5, N6, N7 étant des valeurs de l'amplitude N du signal d'entrée à prédéterminer pour le cas particulier et K3, K4, K5, K6, K11 étant des valeurs à prédéterminer de telle manière que, d'une part, on évite des brouillages et la représentation de déplacement est améliorée pour des points d'image d'amplitude relativement importante, et que, d'autre part des points d'image d'amplitude relativement faible sont sortis du bruit à l'aide du processus et des signaux d'entrée qui, contrairement aux échos fixes, correspondent dans la zone explorée à des déplacements, sont accentués (Fig. 7).

3. Dispositif (27, 271) de préparation de signaux d'image destiné à un système de représentation ultrasonique pour engendrer une image ultrasonique en coupe transversale d'un corps,

plusieurs détections successives du corps qui se recouvrent partiellement et sont exécutées par lignes selon le procédé d'écho d'impulsion dans un plan de détection étant exécutées à l'aide du système afin d'engendrer des signaux d'image sous forme numérique qui correspondent aux échos reçus, chaque détection comprenant un nombre prédéterminé de lignes de détection et chacune de celles-ci comprenant un nombre prédéterminé de points de détection, un intervalle de temps prédéterminé étant prévu entre des détections successives de points de détection correspondants,

ce système comprenant un dispositif ultrasonique de détection (141, 114), un émetteur (15, 151) qui lui est relié, un récepteur (26, 261) relié au dispositif de détection ultrasonique, un moniteur de télévision (24) relié au récepteur et une unité de commande (25, 251) reliée à l'émetteur, au récepteur et au moniteur de télévision,

le récepteur comprenant un circuit détecteur (18) pour engendrer un signal analogique de sortie qui représente respectivement l'écho reçu, et

le dispositif (27, 271) de préparation de signaux d'image étant caractérisé,

a) en ce qu'il (27, 271) est monté en aval du circuit détecteur (18) du récepteur (26, 261) et contient un convertisseur analogique à numérique (19) monté en aval du circuit détecteur (18), une mémoire numérique d'image (22) montée en aval de ce convertisseur, un convertisseur numérique à analogique (23) monté en aval de la mémoire d'image, et un filtre numérique non linéaire (21), qui possède la structure d'un filtre récursif,

b) en ce que ce filtre (21) est monté entre le convertisseur analogique à numérique (19) et le convertisseur numérique à analogique (23) et contient deux additionneurs (33, 41), au moins un élément de retard (34) grâce auquel peut être introduit un retard du signal d'entrée du filtre dont la durée est égale à l'intervalle de temps prédéterminé qui est prévu entre deux détections successives de points de détection correspondants, et trois multiplicateurs (32, 35, 42) à coefficients, pour des coefficients de filtre B1 et B2 et pour des coefficients de rétroaction A (Fig. 5), et

c) en ce que le coefficient de rétroaction A du multiplicateur (42) à coefficient introduit dans le trajet de rétroaction, le coefficient de filtre B1 du multiplicateur (32) à coefficient introduit dans le filtre dans le trajet non retardé de signaux pour des signaux d'entrée non retardés dans le filtre et le coefficient B2 de filtre du multiplicateur (35) à coefficient introduit dans le trajet non retardé de signaux dans le filtre pour des signaux d'entrée retardés dans le filtre sont définis par les conditions suivantes, en fonction de l'amplitude N du signal d'entrée du filtre:

- pour des valeurs relativement très faibles de N dans une zone comprise entre une valeur très faible N8 et une valeur relativement plus importante N10, A = K7,

- pour des valeurs relativement basses et moyennes de N dans une zone comprise entre la valeur N10 et une valeur relativement plus grande N11:

le coefficient A diminue progressivement en variant de façon non monotone en partant d'une valeur A = K7 lorsque l'amplitude N augmente jusqu'à ce qu'il atteigne, pour N = N11, la valeur A = K12, K12 étant égal ou supérieur à 0;

- pour des valeurs relativement très faibles de N dans une zone comprise entre la très petite valeur N8 et une valeur relativement plus importante N9 et pour des valeurs croissantes de N, B1 diminue en partant d'une valeur B1 = K7 et B2 diminue à partir d'une valeur B2 = 0 jusqu'à ce que B1 et B2 atteignent, pour la valeur N = N9, la même valeur K8;

- pour des valeurs de N qui sont égales ou supérieures à N9, B1 = B2, ces coefficients augmentant progressivement en variant de façon non monotone lorsque l'amplitude N augmente, et

N8, N9, N10 étant des valeurs de l'amplitude N du signal d'entrée à prédéterminer pour le cas particulier et K7, K8, K12 étant des valeurs à prédéterminer de telle manière que, pour un rapport signal sur bruit amélioré, d'une part, on évite des brouillages et la représentation de déplacement est améliorée pour des points d'image d'amplitude relativement importante, et que, d'autre part des points d'image d'amplitude relativement faible sont sortis du bruit à l'aide du processus et des signaux d'entrée qui, contrairement aux échos fixes, correspondent dans la zone explorée à des déplacements, sont accentués (Fig. 8).

4. Appareil de représentation d'images ultrasoniques destiné à engendrer des images ultrasoniques d'un corps en coupe transversale, au moyen duquel peuvent être exécutées plusieurs détections successives du corps, se recouvrant au moins partiellement, exécutées par lignes selon le procédé d'écho d'impulsion dans un plan de détection, pour engendrer des signaux d'image sous forme numérique qui correspondent aux échos reçus,

chaque détection comprenant un nombre prédéterminé de lignes de détection et chacune de celles-ci comprenant un nombre prédéterminé de points de détection, un intervalle de temps prédéterminé étant prévu entre des détections successives de points de détection correspondants,

cet appareil comprenant un dispositif ultrasonique de détection (141, 114), un émetteur (15, 151) qui lui est relié, un récepteur (26, 261) relié au dispositif de détection ultrasonique, un moniteur de télévision (24) relié au récepteur et une unité de commande (25, 251) reliée à l'émetteur, au récepteur et au moniteur de télévision,

le récepteur comprenant un circuit détecteur (18) pour engendrer un signal analogique de sortie qui représente respectivement l'écho reçu, caractérisé en ce que,

16

le recépteur contient un dispositif (27, 271) de préparation de signaux d'image selon une des revendications 1-3.

Fig. 1

**ULTRASCHALL-ABTAST-VORRICHTUNG** 141

EMPFÄNGER 26

10

DUPLEXER 14

TIEFEN-AUSGLEICHS-VERSTÄRKER 16

LOGARITH-MISCHER VERSTÄRKER 17

29

DETEKTOR 18

91

A/D UM-SETZER 19

31

MOTOR 12

13

SENDER 15

FERNSEH-MONITOR 24

D/A UMSETZER 23

BILDSPEICHER/NORMWANDLER 22

36

NICHT LINEARER-DIGITALER FILTER 21

MOTOR-STEUERUNG

STEUERELEKTRONIK 25

361

BILDSIGNAL AUFBEREITUNGSVORRICHTUNG

27

EP 0 219 098 B1

**Fig. 2**

# Fig. 3

BILDSIGNALAUFBEREITUNSVORRICHTUNG

271

91

| A/D UMSETZER | NICHT LINEARER DIGITALER FILTER | BILD SPEICHER/ NORM WANDLER | AUSWERTE- EINHEIT | D/A UMSETZER |
|---|---|---|---|---|

31    36

361

19    21    22    221    23

EP 0 219 098 B1

Fig. 4

Fig. 5

Fig: 6

EP 0 219 098 B1

Fig. 7

EP 0 219 098 B1

Fig. 8

Fig. 4